# FASCICULE DE BREVET EUROPEEN

(11) **EP 0 589 763 B1**
(45) Date de publication et mention de la délivrance du brevet: **19.03.1997**
(21) Numéro de dépôt: 93402282.3
(22) Date de dépôt: 20.09.1993
(51) Int. Cl.: H03K 5/13

(54) **Circuit à retard**
Verzögerungsschaltung
Delay-circuit

(30) Priorité: 22.09.1992 FR 9211267
(43) Date de publication de la demande: 30.03.1994
(73) Titulaire: FRANCE TELECOM, 75015 Paris (FR)
(72) Inventeur: Rainard, Jean-Luc, F-38660 La Terrance (FR)
(74) Mandataire: Casalonga, Axel

(56) Documents cités:
- EP-A- 0 059 802
- EP-A- 0 423 963
- EP-A- 0 439 203
- EP-A- 0 474 534
- EP-A 0 539 831

## Description

L'invention concerne l'élaboration d'un retard variable et commandable pour retarder temporellement un signal.

Les circuits à retard variable sont utilisés dans de nombreux dispositifs tels que des oscillateurs commandés en tension, des boucles d'asservissement de phase, des lignes à retard ou des systèmes de suréchantillonnage. Compte tenu de cette très grande utilité, les circuits à retard variable ont fait l'objet de nombreuses études et ont abouti à différentes techniques de réalisation que l'homme du métier regroupe habituellement en trois familles principales.

La première famille concerne les circuits à retard réalisés à l'aide d'amplificateurs différentiels où la variation du temps de propagation entre l'entrée et la sortie est obtenue en agissant sur le courant de mode commun. Une telle réalisation est par exemple décrite dans l'article de Giebel et autres, Digitally Controlled Oscillator, IEEE Journal of Solid-state Circuits, Vol. 24, No.6, Juin 1989.

Une autre famille de circuits à retards regroupe ceux dits à privation de courant (current starving), qui sont basés sur des structures inverseuses classiques, par exemple des inverseurs de technologie CMOS dont le temps de propagation varie en fonction du courant maximum d'alimentation qui leur est imposé par un système de commande approprié. On peut citer à cet effet l'article de Deog-Kyoon Jeong et autres, Design of PLL-Based Clock Generation Circuits, IEEE Journal of Solid-State Circuits, Vol.sc-22, No.2, Avril 1987.

On peut également citer EP-A-0 059 802 dont la structure inverseuse s'apparente à une structure du type à privation de courant.

La troisième famille regroupe les circuits à retard à charge variable qui exploitent la variation du temps de propagation d'un circuit logique, tel qu'un inverseur, en fonction de la valeur de sa charge de sortie. Un tel exemple de réalisation est illustré dans l'article de Johnson et autres, A Variable Delay Line PLL for CPU-Coprocessor Synchronization, IEEE Journal of Solid-State Circuits, Vol. 23, No.5, Octobre 1988. Dans ce circuit à retard antérieur, la charge de sortie est constituée d'un transistor à effet de champ connecté en série avec une capacité. Le transistor à effet de champ est commandé sur sa grille par un signal de commande et peut être considéré comme une résistance commandée en tension dont la variation de valeur modifie l'impédance de la charge de sortie et par conséquent le temps de charge et de décharge de la capacité, ce qui influe sur la valeur du retard.

Toutes les réalisations de cette troisième famille sont par construction commandées par un signal de commande analogique continu (tension ou courant). Ceci conduit à deux inconvénients principaux. Les signaux de commande analogiques utilisés pour piloter la valeur des retards sont sensibles aux bruits internes du circuit, ce qui se répercute alors sur la valeur du retard temporel final. Par ailleurs, la variation du retard en fonction de la tension ou du courant de commande n'est pas linéaire et il en découle généralement des difficultés de mise en oeuvre.

Dans cette troisième famille on peut également citer le document EP-A-0 474 534 décrivant un circuit à constante de temps modifiable par la modification des résistances drain-source des divers transistors.

Le document EP-A 0 539 831, qui concerne un état de la technique selon l'article 54(3) de la Convention sur le Brevet Européen, divulgue un circuit à retard variable et commandable, comprenant une entrée de signal, une entrée de commande pour un signal de commande, une sortie de signal pour délivrer un signal retardé temporellement par rapport au signal d'entrée, et des moyens de retard comportant un circuit logique connecté entre l'entrée et la sortie de signal, ainsi qu'un circuit de charge comportant au moins une capacité commandable connectée en sortie du circuit logique, l'impédance du circuit de charge étant modifiable sous l'action du signal de commande pour faire varier ledit retard. La capacité commandable comporte un transistor à effet de champ à grille isolée dont le drain et la source sont reliés à l'entrée de commande et dont la grille est reliée à la sortie du circuit logique, la capacité commandable étant dans son état actif ou passif en fonction de la valeur de la tension du noeud drain-source.

L'invention vise à apporter une solution à ces problèmes.

Elle propose un circuit à retard du type de celui appartenant à la troisième famille précitée, mais dont le principe de fonctionnement et la structure diffèrent radicalement de ceux déjà connus.

L'invention a également pour but d'obtenir une linéarité d'évolution du retard en fonction du signal de commande.

Un autre but de l'invention est de commander directement la variation du retard à partir d'un signal numérique.

L'invention a encore pour but de proposer un circuit de retard dont la réalisation très simple ne fait pas appel à des techniques analogiques.

Telle que revendiquée, l'invention a pour objet un circuit à retard variable et commandable, comprenant une entrée de signal, une entrée de commande pour un signal de commande, une sortie de signal pour délivrer un signal retardé temporellement par rapport au signal d'entrée, et des moyens de retard comportant un circuit logique connecté entre l'entrée et la sortie de signal, ainsi qu'un circuit de charge comportant une charge capacitive connectée en sortie du circuit logique, l'impédance du circuit de charge étant modifiable sous l'action du signal de commande pour faire varier ledit retard. Selon l'invention le circuit logique comporte une structure inverseuse à deux transistors dont les grilles respectives sont reliées à l'entrée de signal; ladite charge capacitive connectée à la sortie de la structure inverseuse comprend au moins une capacité commandable comportant au moins un transistor à effet de champ à grille isolée dont le drain et la source sont reliés ensemble à la sortie du circuit logique; les moyens de retard comportent des moyens, reliés à l'entrée de commande et à la grille du transistor à effet de champ à grille isolée, aptes à recevoir le signal de commande numérique comportant au moins un mot numérique susceptible de prendre différentes valeurs, et à délivrer une tension de commande à la grille du transistor à effet de champ à grille isolée, ladite tension de commande étant susceptible de prendre deux valeurs différentes en fonction de la valeur du mot numérique, ces deux valeurs étant situées de part et d'autre de la tension de seuil du transistor à effet de champ à grille isolée, la capacité prenant un état passif dans lequel elle est sans effet sur la valeur du retard ou un état actif dans lequel elle influe sur la valeur de ce retard, en fonction de la valeur de la tension de grille,

l'impédance du circuit de charge étant ainsi modifiable par la modification de la valeur capacitive de la charge capacitive.

La charge capacitive peut comporter une pluralité de capacités connectées en sortie du circuit logique, commandables individuellement ou par groupe sous l'action du signal de commande.

Selon un mode préféré de réalisation de l'invention, la pluralité de capacités commandables connectées en parallèle à la sortie du circuit logique possèdent des valeurs capacitives respectives formant une suite géométrique de raison 2, le signal de commande comportant alors une pluralité de mots numériques successifs susceptibles d'activer successivement l'une au moins des capacités dans un ordre prédéterminé conférant à la charge capacitive des valeurs capacitives formant une suite arithmétique.

On peut alors choisir de préférence des capacités de valeurs capacitives élémentaires sensiblement identiques, et regroupées en groupes contenant des nombres respectifs de capacités formant ladite suite géométrique de raison 2; chaque mot numérique du signal de commande active alors au moins un groupe de capacités dans un ordre prédéterminé pour obtenir le pas de ladite suite arithmétique égal à la capacité élémentaire.

Le circuit logique est de préférence un inverseur comportant deux transistors à effet de champ à grille isolée complémentaires dont le transistor à effet de champ à canal P possède avantageusement une largeur de canal supérieure à celle du transistor à canal N de cet inverseur.

Selon un autre mode de réalisation de l'invention, le circuit de charge peut comporter une pluralité de moyens de retard analogues et connectés en série.

D'autres avantages et caractéristiques de l'invention apparaîtront à l'examen de la description détaillée d'un mode de réalisation nullement limitatif et illustré sur les dessins sur lesquels:
- la figure 1 représente un synoptique schématique d'un circuit à retard selon l'invention,
- la figure 2 représente plus en détail le groupement de capacités du circuit de la figure 1,
- les figures 3 et 4 illustrent des modes de réalisation de ces capacités,
- la figure 5 représente une évolution du retard obtenu en fonction du signal de commande, et
- la figure 6 illustre un autre mode de réalisation du circuit à retard selon l'invention.

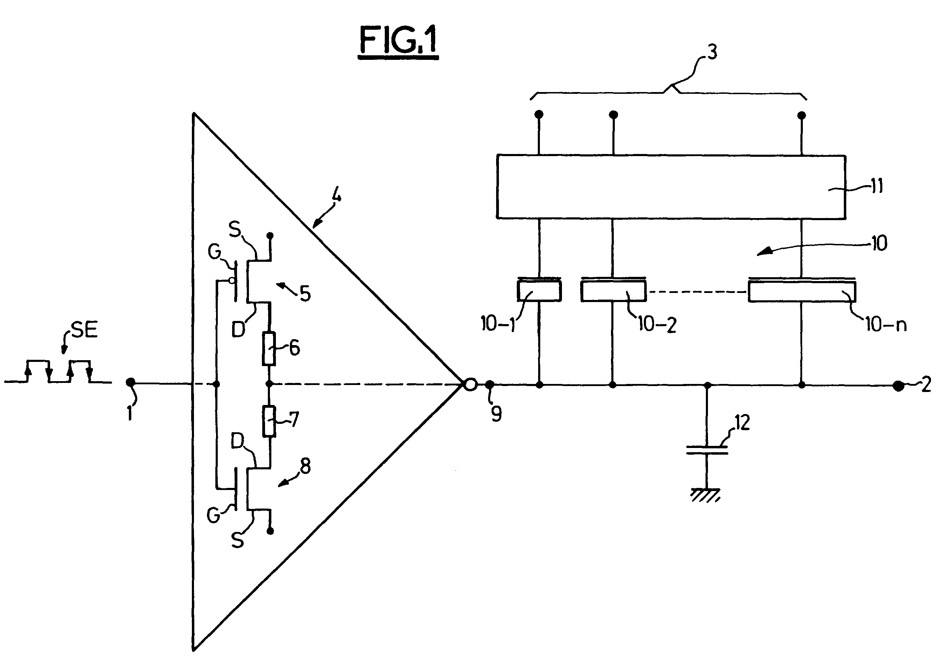

Sur la figure 1, la référence 1 désigne une entrée de signal du circuit à retard tandis que la référence 2 se rapporte à une sortie de signal apte à délivrer un signal de sortie retardé temporellement par rapport au signal d'entrée. Ce signal d'entrée SE est avantageusement composé d'une alternance de fronts montants et descendants. Entre cette entrée et cette sortie de signal, sont connectés des moyens de retard comportant ici un inverseur logique 4 dont l'entrée est reliée à l'entrée de signal et dont la sortie 9 est reliée à la sortie de signal 2. Cet inverseur 4 est ici classiquement réalisé à partir de deux transistors à effet de champ à grille isolée complémentaires 5 et 8, dont les drains respectifs D sont reliés à la sortie de l'inverseur et dont les grilles respectives G sont reliées à l'entrée de cet inverseur. Les transistors à effet de champ à grilles isolées 5 et 8 présentent une composante résistive dont on a schématiquement représenté ici les valeurs résistives par deux résistances 6 et 7 respectivement connectées entre les drains des transistors et la sortie de l'inverseur.

En sortie 9 de cet inverseur 4, est connectée une charge capacitive 10 composée ici d'une pluralité de capacités en parallèle 10-1...10-n. Cette charge capacitive 10 est reliée à une entrée de commande 3, apte à recevoir un signal de commande, par l'intermédiaire de moyens logiques 11 dont on reviendra plus en détail sur la structure et la fonction ci-après. La capacité 12 connectée entre la sortie 9 de l'inverseur et la masse représente la capacité parasite Cp du circuit.

La charge capacitive 10, la capacité parasite 12 et les résistances 6 et 7 des transistors à effet de champ à grille isolée 5 et 8 forment un circuit de charge pour ces moyens de retard. Selon le principe général de fonctionnement d'un tel circuit à retard, la charge capacitive 10 va successivement se charger et se décharger au travers des résistances 6 et 7. L'inverseur 4 va changer d'état, c'es t-à-dire délivrer un front descendant en présence d'un front montant à l'entrée et réciproquement, généralement au bout du temps nécessaire à la charge capacitive pour atteindre la moitié de sa charge. Or, ce temps de charge et de décharge dépend de la constante de temps RC du circuit de charge, où R désigne la valeur résistive et C la valeur capacitive de ce circuit de charge. Selon l'invention, on modifie cette constante de temps en modifiant directement la valeur capacitive intrinsèque de la charge capacitive 10. Ce principe est donc totalement différent de celui connu antérieurement qui consiste à agir sur la valeur de la résistance en modulant sa valeur par un signal de commande analogique (tension ou courant).

Le signal de commande utilisé ici, et arrivant à l'entrée de commande 3, est un mot numérique permettant d'activer ou de désactiver l'une au moins des capacités 10-1...10-n de la charge capacitive 10, selon la valeur des bits de ce mot numérique. Une capacité sera considérée comme activée et sera alors dans un état dit "actif" lorsque, sous l'action du signal de commande, elle sera susceptible de se charger et de se décharger pour influer sur la valeur du retard. Par contre, une telle capacité sera considérée comme désactivée, et sera dans un état passif, lorsque, sous l'action du signal de commande, elle n'aura aucune influence sur la valeur du retard. Il convient de remarquer ici que l'utilisation d'un mot numérique comme signal de commande, permet de commander une capacité en tout ou rien, c'est-à-dire de la considérer comme intégralement incoporée au circuit de charge avec sa valeur capacitive intrinsèque nominale ou bien la considérer comme inexistante vis-à-vis de ce circuit de charge. Il n'est donc pas envisagé ici de moduler la valeur capacitive d'une telle capacité, contrairement à ce qu'il était possible de faire pour une résistance avec un signal de commande analogique dans les dispositifs de l'art antérieur. On obtient donc ainsi un circuit de retard très peu sensible au bruit et qui permet d'obtenir directement, avec un choix approprié de capacité, une bonne linéarité de l'évolution du retard en fonction de la commande.

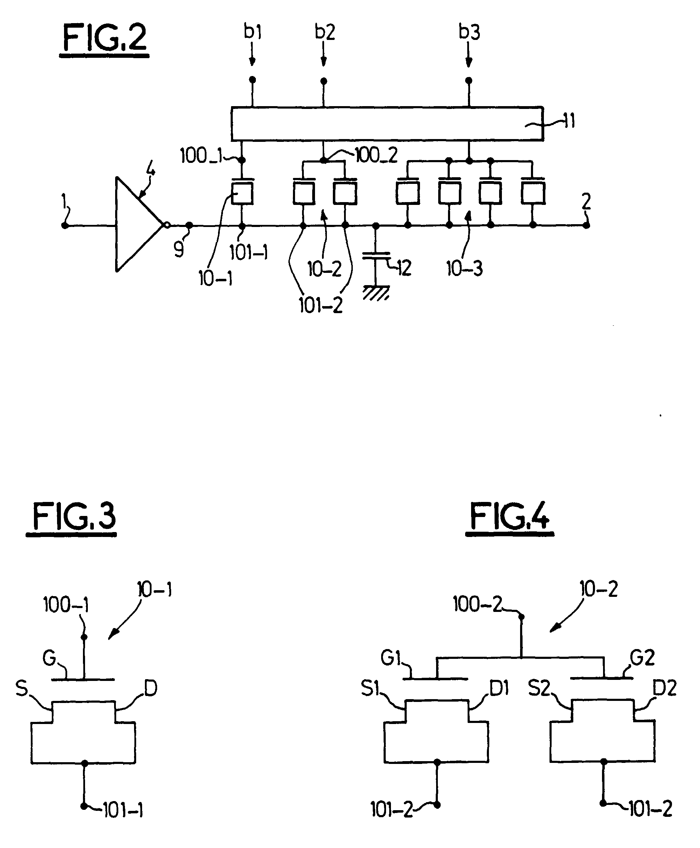

Cette dernière possibilité est obtenue en conférant successivement à la charge capacitive 10 des valeurs discrètes, prises parmi un jeu prédéterminé de valeurs, et suivant un évolution sensiblement linéaire. Un tel mode de réalisation est illustré sur la figure 2.

La charge capacitive 10 est constituée de plusieurs groupes (ici trois) de capacités ayant toutes sensiblement la même valeur capacitive intrinsèque élémentaire C. Les nombres respectifs de capacités de ces différents groupes forment une suite géométrique de raison 2. Ainsi, le premier groupe 10-1 ne comporte qu'une seule capacité tandis que le deuxième groupe 10-2 en comporte deux et que le troisième groupe 10-3 en comporte quatre. De ce fait, on obtient, en sortie de l'inverseur, une pluralité de capacités commandables possédant des valeurs capacitives respectives formant une suite géométrique de raison 2 et de premier terme. En effet, la valeur capacitive du premier groupe est égale à C, tandis que celle du deuxième groupe est égale à 2C et que celle du troisième groupe est égale à 4C.

Le signal de commande va alors avantageusement être composé de plusieurs mots numériques composés chacun d'une pluralité de bits en un nombre égal à la pluralité de groupes (ici trois), tous ces mots numériques étant susceptibles d'activer successivement l'un au moins de ces groupes dans un ordre prédéterminé conférant à la charge capacitive 10 10 des valeurs capacitives formant une suite arithmétique de pas égal à la valeur C de la capacité élémentaire. En d'autres termes, si chaque mot numérique du signal de commande comporte trois bits b1, b2, b3, et si l'on confère aux bits de chacun de ces mots numériques, des valeurs telles que soient successivement activés le premier groupe 10-1, puis le deuxième groupe, puis le premier et le deuxième groupes ensemble, puis le troisième groupe, puis le troisième et le premier groupes ensemble, et ainsi de suite, on obtiendra, pour la charge capacitive 10, des valeurs successivement égales à C, 2C, 3C, 4C, 5C....

Chaque capacité peut être constitué d'un transistor à effet de champ à grille isolée, par exemple à canal N, tel qu'illustré sur la figure 3. La grille G de ce transistor est reliée à la borne 100-1 elle-même reliée à la sortie des moyens 11 tandis que la source S et le drain D d'un tel transistor sont reliés ensemble à la borne 101-1 relié à la sortie 9 de l'inverseur. Aussi, dans un tel mode de réalisation, la capacité est dans son état actif ou passif en fonction de la valeur de la tension de grille relativement à la tension de seuil du transistor. En effet, si la tension de grille est à une tension inférieure à la tension de seuil, la zone de canal située sous cette grille n'est pas déplétée et le transistor à effet de champ présente alors une capacité connectée entre la grille et le substrat, qui est donc sans influence vis-à-vis de l'inverseur 4. Par contre, si la grille est portée à une tension supérieure à la tension de seuil, la zone de canal est déplétée et le transistor présente une capacité connectée entre la grille et le drain (et la source) ce qui la rend active vis-à-vis de l'inverseur 4.

On aurait pu utiliser, à la place d'un transistor à effet de champ à grille isolée faisant office de capacité, un condensateur de valeur capacitive équivalente, commandé par un transistor par exemple à effet de champ. Dans ce cas, la capacité serait reliée entre le drain du transistor et la sortie 9 de l'inverseur et serait électriquement incorporée dans le circuit de charge en fonction de la tension de grille du transistor agissant alors comme un simple interrupteur.

Dans le cas des deuxième et troisième groupes comportant des capacités en parallèle, on peut utiliser, comme illustré sur la figure 4 pour le groupe 10-2, des transistors connectés en parallèle. Dans ce cas, les deux grilles G1 et G2 de deux transistors sont reliées ensemble à la borne 100-2 tandis que les sources S1 et S2 et les drains D1 et D2 de ces deux transistors sont reliés ensemble à la borne 101-2.

Les moyens 11 sont aptes à recevoir le signal de commande et à délivrer une tension de commande à la grille du transistor, susceptibles de prendre deux valeurs différentes en fonction de la valeur du mot numérique, ces deux valeurs étant situées de part et d'autre de la tension de seuil des transistors. On utilisera par exemple pour les moyens 11, des moyens logiques tels que des portes logiques délivrant une tension de commande de grille, nulle ou égale à 5 Volts par exemple, en fonction de la valeur du mot binaire d'entrée.

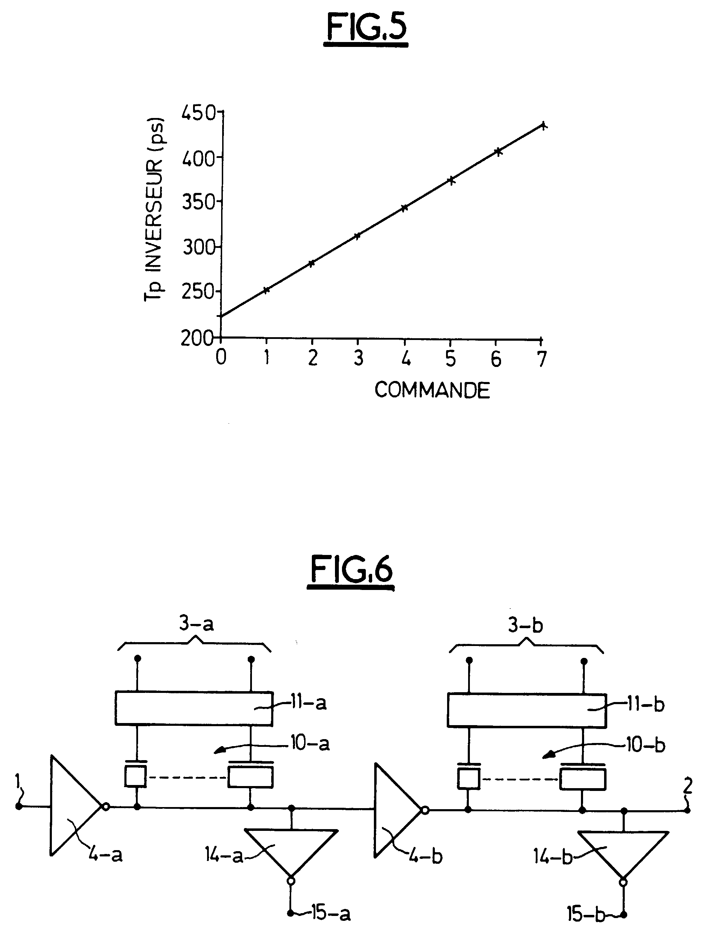

La commande numérique directe (c'est-à-dire sans passer par l'intermédiaire d'une commande analogique autre bien sûr que celle consistant uniquement à la délivrance de deux valeurs analogiques correspondant directement aux deux valeurs d'un bit) à haute impédance d'entrée selon l'invention, a permis d'obtenir, comme illustrée sur la figure 5, une linéarité de la variation du temps de propagation Tp de l'inverseur en fonction de la valeur du mot de commande, de l'ordre de 1%. Sur cette courbe, les valeurs 0 à 7 correspondent aux huit valeurs décimales des huit mots numériques successifs du signal de commande, composés chacun des bits b3, b2, b1, les valeurs binaires correspondantes de ces mots allant de 000 à 111. Bien entendu, l'homme du métier aura compris que cette évolution du temps de propagation Tp de l'inverseur abusivement qualifiée de linéaire est en fait une évolution affine au sens mathématique du terme compte tenu de la valeur Cp de la capacité parasite 12 du circuit.

Le circuit logique utilisé ici est un inverseur réalisé en technologie CMOS bien que l'on puisse utiliser d'autres circuits logiques, par exemple à base de portes NON ET, à condition que ces autres circuits logiques soient agencés pour ne pas provoquer de déformations trop importantes entre l'allure des fronts d'entrée et de sortie, ce qui pourrait être interprété faussement comme un retard. Dans le cas où l'on utilise un inverseur à deux transistors complémentaires à grille isolée, il est préférable de prévoir des transistors possédant des caractéristiques dimensionnelles choisies de telle sorte que ces transistors à canal N et P délivrent le même courant maximum dans les mêmes conditions. L'homme du métier sait que la valeur de ce courant dépend de la mobilité des porteurs et du dimensionnement du canal (longueur entre drain et source, et largeur). Aussi, puisque la mobilité des trous est nettement plus faible que celle des électrons, on choisira évantageusement pour une même technologie CMOS, une largeur de canal pour le transistor à canal P supérieure à celle du canal du transistor à canal N. En pratique on adoptera une largeur de canal double. On évite ainsi d'obtenir en sortie un signal "rétréci" par rapport au signal d'entrée, c'est-à-dire présentant un espacement différent entre les fronts descendants et les fronts montants. Un tel signal serait obtenu avec deux transistors complémentaires de caractéristiques dimensionnelles identiques en raison de la valeur résistive plus importante du transistor 5 à canal P.

La figure 6 illustre un mode de réalisation de l'invention, permettant notamment de réaliser des lignes à retard à sorties multiples, dans lequel le circuit à retard comporte une pluralité de moyens de retard analogues 4-a, 10-a, 11-a; 4-b, 10-b, 11-b, reliés en série entre l'entrée 1 et la sortie 2. Dans ce cas, il est avantageusement prévu d'utiliser des inverseurs auxiliaires 14-a et 14-b connectés en sortie de chaque inverseur 4-a et 4-b afin de découpler un module élémentaire du suivant et de pouvoir prélever ainsi des signaux de sortie intermédiaires au niveau des bornes 15-a et 15-b sans influer sur la valeur du retard déterminé par la valeur des charges capacitives 10-a et 10-b.

## Revendications

1. Circuit à retard variable et commandable, comprenant une entrée de signal (1), une entrée de commande (3) pour un signal de commande, une sortie de signal (2) pour délivrer un signal retardé temporellement par rapport au signal d'entrée (SE), et des moyens de retard comportant un circuit logique (4) connecté entre l'entrée et la sortie de signal, ainsi qu'un circuit de charge comportant une charge capacitive (10) connectée en sortie (9) du circuit logique (4), l'impédance du circuit de charge étant modifiable sous l'action du signal de commande pour faire varier ledit retard, caractérisé par le fait que le circuit logique (4) comporte une structure inverseuse à deux transistors dont les grilles respectives sont reliées à l'entrée de signal, par le fait que ladite charge capacitive connectée à la sortie de la structure inverseuse comprend au moins une capacité (10-1..., 10-n) commandable comportant au moins un transistor à effet de champ à grille isolée dont le drain (D) et la source (S) sont reliés ensemble à la sortie du circuit logique (4), par le fait que les moyens de retard comportent des moyens (11), reliés à l'entrée de commande et à la grille du transistor à effet de champ à grille isolée, aptes à recevoir le signal de commande numérique comportant au moins un mot numérique (b3, b2, b1) susceptible de prendre différentes valeurs, et à délivrer une tension de commande à la grille du transistor à effet de champ à grille isolée, ladite tension de commande étant susceptible de prendre deux valeurs différentes (0 V, 5 V) en fonction de la valeur du mot numérique, ces deux valeurs étant situées de part et d'autre de la tension de seuil du transistor à effet de champ à grille isolée, la capacité prenant un état passif dans lequel elle est sans effet sur la valeur du retard ou un état actif dans lequel elle Influe sur la valeur de ce retard, en fonction de la valeur de la tension de grille, l'impédance du circuit de charge étant ainsi modifiable par la modification de la valeur capacitive de la charge capacitive .

2. Circuit selon la revendication 1, caractérisé par le fait que la charge capacitive comporte une pluralité de capacités (10-1... 10-n) connectées en sortie du circuit logique (4), commandables individuellement ou par groupe sous l'action du signal de commande.

3. Circuit selon la revendication 2, caractérisé par le fait que la pluralité de capacités commandables connectées en parallèle à la sortie du circuit logique (4) possèdent des valeurs capacitives respectives formant une suite géométrique de raison deux, et par le fait que le signal de commande comporte une pluralité de mots numériques successifs susceptibles d'activer successivement l'une au moins des capacités dans un ordre prédéterminé conférant à la charge capacitive (10) des valeurs capacitives formant une suite arithmétique.

4. Circuit selon la revendication 3, caractérisé par le fait que les capacités sont de valeur capacitive élémentaire (C) sensiblement identique et sont regroupées en groupes (10-1, 10-2, 10-3) contenant des nombres respectifs de capacités formant ladite suite géométrique de raison deux, et par le fait que les mots numériques (000,...,111) du signal de commande activent successivement au moins un groupe de capacités dans un ordre prédéterminé pour conférer à ladite suite arithmétique un pas égal à la capacité élémentaire (C).

5. Circuit selon l'une des revendications 1 à 4, caractérisé par le fait que la structure inverseuse comporte deux transistors à effet de champ à grille isolée, complémentaires.

6. Circuit selon la revendication 5, caractérisé par le fait que le transistor à effet de champ à canal P (5) de la structure inverseuse (4) possède une largeur de canal supérieure à celle du transistor à canal N(8) de cet inverseur.

7. Circuit selon l'une des revendication 1 à 6, caractérisé par le fait qu'il comporte une pluralité de moyens de retard analogues connectés en série (4-a, 10-a, 11-a; 4-b, 10-b, 11-b).

## Patentansprüche

1. Variable und steuerbare Verzögerungsschaltung, mit einem Signaleingang (1), einem Steuereingang (3) für ein Steuersignal, einem Signalausgang (2) zur Ausgabe eines gegenüber dem Eingangssignal (SE) zeitlich verzögerten Signals und mit Verzögerungsmitteln, welche eine zwischen den Signaleingang und den Signalausgang geschaltete Logikschaltung (4) sowie einen Lastkreis, der eine an den Ausgang (9) der Logikschaltung (4) geschaltete kapazitive Last (10) enthält, umfaßt, wobei die Impedanz des Lastkreises unter der Wirkung des Steuersignals veränderbar ist, um die genannte Verzögerung zu variieren, dadurch gekennzeichnet, daß die Logikschaltung (4) eine Inverter-Struktur mit zwei Transistoren umfaßt, der jeweilige Gate-Elektroden mit dem Signaleingang verbunden sind, daß die genannte, mit dem Ausgang der Inverter-Struktur verbundene kapazitive Last mindestens eine steuerbare Kapazität (10-1 ..., 10-n) umfaßt, welche mindestens einen Feldeffekttransistor mit isolierter Steuerelektrode aufweist, dessen Drain-Elektrode (D) und Source-Elektrode (S) gemeinsam mit dem Ausgang der Logikschaltung (4) verbunden sind, daß die Verzögerungsmittel mit dem Steuereingang und der Gate-Elektrode des Feldeffekttransistors mit isolierter Steuerelektrode verbundene Mittel (11) umfassen, welche in der Lage sind, das digitale Steuersignal, welches mindestens ein Digitalwort (b3, b2, bl) umfaßt, das verschiedene Werte anzunehmen vermag, zu empfangen und eine Steuerspannung an die Gate-Elektrode des Feldeffekttransistors mit isolierter Steuerelektrode anzulegen, wobei die genannte Steuerspannung zwei unterschiedliche Werte (0 V, 5 V) in Abhängigkeit vom Wert des Digitalwortes anzunehmen vermag, wobei die beiden Werte beiderseits der Schwellenspannung des Feldeffekttransistors mit isolierter Steuerelektrode liegt, wobei die Kapazität einen passiven Zustand, in welchem sie ohne Wirkung auf den Verzögerungswert ist, oder einen aktiven Zustand, in welchem sie den Wert dieser Verzögerung beeinflußt, in Abhängigkeit von dem Wert der Gate-Spannung annimmt, und wobei die Impedanz des Lastkreises so durch die Veränderung des Kapazitätswertes der kapazitiven Last veränderbar ist.

2. Schaltung nach Anspruch 1, dadurch gekennzeichnet, daß die kapazitive Last eine Mehrzahl von Kapazitäten (10-1 ... 10-n) umfaßt, welche mit dem Ausgang der Logikschaltung (4) verbunden sind und einzeln oder als Gruppe unter der Wirkung des Steuersignals steuerbar sind.

3. Schaltung nach Anspruch 2, dadurch gekennzeichnet, daß die Mehrzahl von steuerbaren Kapazitäten, die parallel mit dem Ausgang der Logikschaltung (4) verbunden sind, jeweils Kapazitätswerte aufweist, welche eine geometrische Reihe mit dem Quotienten (2) bilden, und daß das Steuersignal eine Mehrzahl von aufeinanderfolgenden Digitalwörtern umfaßt, die in der Lage sind, nacheinander die mindestens eine der Kapazitäten in einer vorgegebenen Reihenfolge zu aktivieren, um der kapazitiven Last (10) Kapazitätswerte hinzuzufügen, welche eine arithmetische Reihe bilden.

4. Schaltung nach Anspruch 3, dadurch gekennzeichnet, daß die Kapazitäten einen annähernd identischen elementaren Kapazitätswert (C) besitzen und in Gruppen (10-1, 10-2, 10-3) angeordnet sind, welche jeweils eine entsprechende Anzahl von Kapazitäten umfassen, daß sie die genannte geometrische Reihe mit dem Quotienten Zwei bilden und daß die Digitalwörter (000, ..., 111) des Steuersignals nacheinander mindestens eine Gruppe von Kapazitäten in einer vorgegebenen Reihenfolge aktivieren, um der genannten arithmetischen Reihe eine Differenz gleich der elementaren Kapazität (C) hinzuzufügen.

5. Schaltung nach einem der Ansprüche 1 bis 4, dadurch gekennzeichnet, daß die Inverter-Struktur zwei komplementäre Feldeffekttransistoren mit isolierter Steuerelektrode umfaßt.

6. Schaltung nach Anspruch 5, dadurch gekennzeichnet, daß der Feldeffekttransistor mit P-Kanal (5) der Inverter-Struktur (4) eine Kanalbreite besitzt, die größer ist als diejenige des Transistors mit N-Kanal (8) dieses Inverters.

7. Schaltung nach einem der Ansprüche 1 bis 6, dadurch gekennzeichnet, daß sie eine Mehrzahl von in Serie geschalteten analogen Verzögerungsmitteln (4-a, 10-a, 11-a; 4-b, 10-b, 11-b) bilden.

## Claims

1. Variable and controllable delay circuit, comprising a signal input (1), a control input (3) for a control signal, a signal output (2) for delivering a signal which is time delayed with respect to the input signal (SE), and delay means including a logic circuit (4) connected between the signal input and the signal output, as well as a load circuit including a capacitive load (10) connected at the output (9) of the logic circuit (4), the impedance of the load circuit being alterable under the action of the control signal in order to vary the said delay, characterized in that the logic circuit (4) includes an inverting structure having two transistors whose respective gates are linked to the signal input, in that the said capacitive load connected to the output of the inverting structure comprises at least one controllable capacitor (10-1...., 10-n) which includes at least one insulated-gate field-effect transistor whose drain (D) and source (S) are connected together to the output of the logic circuit (4), in that the delay means include means (11), connected to the control input and to the gate of the insulated-gate field-effect transistor, which are able to receive the digital control signal, which includes at least one digital word (b3, b2, b1) capable of taking various values, and to deliver a control voltage to the gate of the insulated-gate field-effect transistor, the said control voltage being capable of taking two different values (0 V, 5 V) depending on the value of the digital word, these two values being situated on either side of the threshold voltage of the insulated-gate field-effect transistor, the capacitor taking a passive state in which it has no effect on the value of the delay or an active state in which it influences the value of this delay, depending on the value of the gate voltage, the impedance of the load circuit thus being alterable by altering the capacitive value of the capacitive load.

2. Circuit according to Claim 1, characterized in that the capacitive load includes a plurality of capacitors (10-1 ... 10-n) connected at the output of the logic circuit (4), which are controllable individually or as a group under the action of the control signal.

3. Circuit according to Claim 2, characterized in that the plurality of controllable capacitors connected in parallel to the output of the logic circuit (4) possess respective capacitive values forming a geometric series with common ratio two, and in that the control signal includes a plurality of successive digital words successively capable of activating at least one of the capacitors in a predetermined order conferring capacitive values on the capacitive load (10) forming an arithmetic series.

4. Circuit according to Claim 3, characterized in that the capacitors are of substantially identical elementary capacitive value (C) and are grouped together in groups (10-1, 10-2, 10-3) containing respective numbers of capacitors forming the said geometric series with common ratio two, and in that the digital words (000 111) of the control signal successively activate at least one group of capacitors in a predetermined order in order to confer a step equal to the elementary capacitors (C) on the said arithmetic series.

5. Circuit according to one of Claims 1 to 4, characterized in that the inverting structure includes two complementary insulated-gate field-effect transistors.

6. Circuit according to Claim 5, characterized in that the P-channel field-effect transistor (5) of the inverting structure (4) possesses a channel width greater than that of the N-channel transistor (8) of this inverter.

7. Circuit according to one of Claims 1 to 6, characterized in that it includes a plurality of similar delay means connected in series (4-1, 10-a, 11-a; 4-b, 10-b, 11-b).
